# EUROPÄISCHE PATENTSCHRIFT

(11) **EP 0 476 321 B1**
(45) Veröffentlichungstag und Bekanntmachung des Hinweises auf die Patenterteilung: **23.10.1996**
(21) Anmeldenummer: 91113857.6
(22) Anmeldetag: 19.08.1991
(51) Int. Cl.: G01R 33/38

(54) **Kernspintomograph**
Nuclear spin tomograph
Tomographe en spins nucléaires

(30) Priorität: 20.09.1990 DE 4029816
(43) Veröffentlichungstag der Anmeldung: 25.03.1992
(73) Patentinhaber: SIEMENS AKTIENGESELLSCHAFT, 80333 München (DE)
(72) Erfinder: Siebold, Horst, Dr., W-8520 Erlangen (DE); Ries, Günter, Dr., W-8520 Erlangen (DE); Oppelt, Ralph, Dr., W-8525 Uttenreuth (DE)

(56) Entgegenhaltungen:
- EP-A- 0 217 520
- EP-A- 0 307 516
- GB-A- 2 208 768
- US-A- 4 928 063
- IEEE TRANSACTIONS ON MEDICAL IMAGING, Bd. 7, Nr. 3, September 1988, New York, US, Seiten 247-254; M.A. MORICH : "Exact Temporal Eddy Current Compensation in Magnetic Resonance Imaging Systems"
- JOURNAL OF MAGNETIC RESONANCE, Bd. 87, Nr. 3, Mai 1990, Duluth, MN, US, Seiten 548-553; P.D. MAJORS et al.: "Eddy Current Compensation by Direct Field Detection and Digital Gradient Modification"

## Beschreibung

Die Erfindung bezieht sich auf einen Kernspintomographen zur Untersuchung eines menschlichen Körpers, dessen Körperachse sich in Richtung der x-Achse eines rechtwinkligen Koordinatensystems erstreckt und dessen zu untersuchender Körperbereich sich zwischen wenigstens annähernd ebenen Polflächen eines Grundfeldmagneten befindet. Das magnetische Grundfeld B_{O} erstreckt sich in Richtung der z-Achse. Ferner sind Gradientenspulen vorgesehen, die parallel zu den Polflächen des Grundfeldmagneten angeordnet sind. Der Magnetkreis enthält im allgemeinen wenigstens in der Nähe seiner Polfläche ferromagnetisches Material.

Zum Herstellen von Schnittbildern eines Körpers und zur Gelenkdiagnostik sowie zur Darstellung von Blutgefäßen können bekanntlich Kernspintomographen verwendet werden, bei denen durch rechnerische oder meßtechnische Analyse integraler Protonenresonanzsignale aus der räumlichen Spinndichte - oder auch der Relaxationszeitenverteilung des zu untersuchenden Körpers - ein Bild konstruiert wird. Der zu untersuchende Körper, insbesondere ein menschlicher Körper, wird in ein starkes homogenes Magnetfeld, das sogenannte Grundfeld, eingebracht, das die Kernspins in einem Abbildungsvolumen zwischen den Polflächen ausrichtet. Ferner sind gepulste Gradientenspulen vorgesehen, die zur Ortsauflösung im Abbildungsvolumen ein räumlich unterschiedliches Magnetfeld erzeugen. Eine Hochfrequenz-Antenne regt die Kernspins an und überträgt das von den angeregten Kernspins emittierte Signal zu einem Empfänger.

Neben den bekannten, für stärkere Magnetfelder etwa oberhalb 0,5 T im allgemeinen supraleitenden Grundfeldmagneten, die als Solenoid ausgeführt sind und ein in Richtung der Körperachse des Patienten verlaufendes statisches Grundfeld erzeugen, können in der Kernspintomographie als Grundfeldmagnet auch Polschuhmagnete verwendet werden, die als sogenannter C-Magnet, H-Magnet oder auch als Rahmen-Magnet (window-frame magnet) ausgeführt werden können (EP-A-0 161 782).

In dieser Ausführungsform eines Kernspintomographen erstreckt sich die Körperachse des Patienten in Richtung der x-Achse eines rechtwinkligen Koordinatensystems. Das Abbildungsvolumen befindet sich zwischen den Polschuhen, die im allgemeinen wenigstens teilweise aus ferromagnetischem Material bestehen, in einem magnetischen Grundfeld B_{O}, das in Richtung der z-Achse verläuft (DE-OS 37 37 133).

Die Gradientenspulen für den Kernspintomographen sind im allgemeinen als Flachspulen ausgeführt und auf den Polschuhen angeordnet, die im allgemeinen wenigstens in der Nähe der Polflächen Weicheisen enthalten, das sowohl magnetisch permeabel als auch elektrisch leitfähig ist. Die Erfindung beruht nun auf der Erkenntnis, daß während des Betriebes Bildstörungen auftreten können, die durch Wirbelströme im Eisen und vom nichtlinearen Verhalten des Eisens durch Sättigungseffekte verursacht werden, wenn der magnetische Fluß der Gradientenspulen das Eisen der Magnetpole durchsetzt.

Die automatische Korrektur von Wirbelströmen ist z.B. aus US-A-4928063 bekannt. Dort empfängt eine Spule das induzierte Gradientensignal, das integriert und zur Korrektur verwendet wird.

Der Erfindung liegt somit die Aufgabe zugrunde, in einem Kernspintomographen der eingangs genannten Art den Frequenz- und Amplitudengang der Gradientenfelder zu linearisieren und die durch Wirbelströme und Sättigungseffekte im Eisen der Polschuhe verursachten Bildstörungen zu beseitigen.

Die Lösung dieser Aufgabe erfolgt gemäß der Erfindung mit dem kennzeichnenden Merkmal des Anspruchs 1. Weitere vorteilhafte Ausgestaltungen der Erfindung ergeben sich aus den Unteransprüchen. Unter Umständen kann es zweckmäßig sein, wenigstens die Gradientenspulen für den Gradienten G_{z} mit einer zusätzlichen Regelung zu versehen, die auch eine dynamische Grundfeldänderung bₒ(t) durch die genannten Effekte kompensiert.

Zur weiteren Erläuterung wird auf die Zeichnung Bezug genommen, in deren Figur 1 ein Kernspintomograph mit einem Grundfeldmagneten für ein transversales Grundfeld B_{O} in der Ausführungsform als C-Magnet schematisch veranschaulicht ist. Figur 2 zeigt einen Regelkreis für den Gradienten Gₓ oder G_{y}, In Figur 3 ist ein Diagramm zur Erläuterung eines Regelkreises dargestellt. Figur 4 zeigt eine Ausführungsform mit getrennten Regelkreisen für die beiden Gradientenspulen des Gradienten G_{z}. Die Figuren 5 und 6 zeigen jeweils eine besondere Ausführungsform eines Regelkreises für den Gradienten G_{z}. In Figur 7 ist eine besondere Ausführungsform einer Sensorspule für die Regelung der Gradienten veranschaulicht. In Figur 8 ist eine Anordnung der Sensorspulen auf den beiden Polflächen dargestellt. Die Figuren 9 bis 13 dienen zur Erläuterung einer elektronischen Vorzeichengewichtung für die einzelnen Sensorspulen.

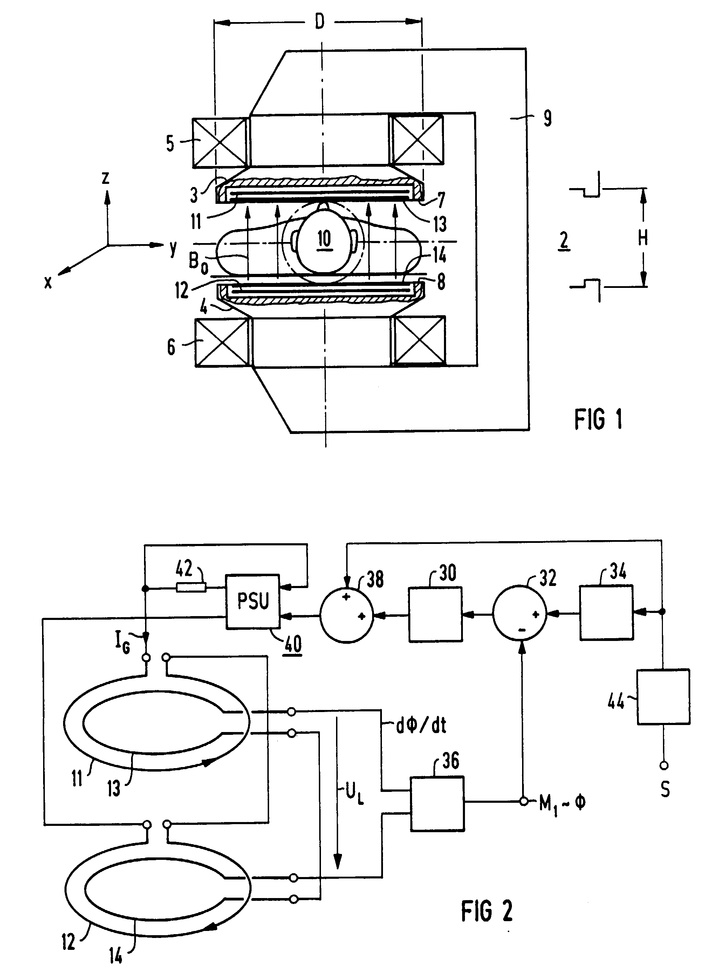

In der Ausführungsform eines Kernspintomographen gemäß Figur 1 mit einem Grundfeldmagneten 2 in der Ausführung beispielsweise als C-Magnet verläuft das statische magnetische Grundfeld parallel zur z-Achse eines rechtwinkligen Koordinatensystems mit den Achsen x, y und z. Dieser Kernspintomograph ist zur Untersuchung eines in der Figur nicht näher bezeichneten Meßobjekts, insbesondere eines menschlichen Körpers, vorgesehen, dessen Körperachse sich in der Richtung der x-Achse des Koordinatensystems erstreckt und dessen zu untersuchender Körperbereich sich im strichpunktiert angedeuteten, etwa kugelförmigen Abbildungsvolumen 10, dessen Durchmesser beispielsweise etwa 40 cm betragen kann, zwischen den Polschuhen 3 und 4 des Grundfeldmagneten 2 befindet. Die nicht näher bezeichneten Pole des Grundfeldmagneten 2 mit einem Durchmesser von beispielsweise d = 100 cm und einem Abstand von beispielsweise H = 45 cm sind mit Feldspulen 5 und 6 versehen, die ein magnetisches Grundfeld B_{O} erzeugen, das im Abbildungsvolumen 10 in Richtung der z-Achse des Koordinatensystems verläuft. Anstatt durch Feldspulen kann der Magnet auch durch Permanentmagnetscheiben erregt sein. Der Nullpunkt des Koordinatensystems, das zur besseren Übersicht außerhalb des Abbildungsvolumens 10 dargestellt ist, soll im Mittelpunkt zwischen den Polflächen 7 und 8 des Grundfeldmagneten 2 liegen, so daß die Feldachse in die nicht näher bezeichnete Rotationsachse der Polschuhe 3 und 4 fällt. Das magnetische Grundfeld B_{O} schließt sich über ein Magnetjoch 9.

In der praktischen Ausführungsform des Kernspintomographen sind im allgemeinen wenigstens die Polflächen 7 und 8, vorzugsweise jedoch die gesamten Pole mit den Feldspulen 5 und 6 und gegebenenfalls auch noch das Magnetjoch mit einer in der Figur nicht dargestellten Abschirmung, für das Hochfrequenzfeld versehen, die aus einem Überzug aus elektrisch leitendem, nichtmagnetischem Metall, vorzugsweise Kupfer, bestehen kann.

In einer in der Figur nicht näher bezeichneten Ausnehmung der Polflächen 7 und 8 ist ein Spulensystem eingelagert, das Gradientenspulen 11 und 12 für einen x-, y- und z-Gradienten enthält, die als Flachspulen ausgeführt sind und die zur Vereinfachung als gemeinsames Spulensystem in der Figur angedeutet sind. In der Ausführungsform eines Kernspintomographen gemäß der Erfindung ist nun den Gradientenspulen 11 und 12 jeweils eine ebenfalls als Flachspule ausgebildete Sensorspule 13 bzw. 14 zugeordnet, die ebenfalls parallel zu den Polflächen 7 und 8 und auch parallel zu den Gradientenspulen 11 und 12 angeordnet sind.

Die Gradientenspulen 11 und 12 sind dem ferromagnetischen Material der Polscheibe 3 und 4 ohne Abschirmung direkt benachbart, so daß ihre Gradientenfelder dort Wirbelströme und magnetische Sättigungseffekte mit entsprechend störender Rückwirkung verursachen. Gemäß der Erfindung ist deshalb eine Regelung des magnetischen Flusses der Gradientenspulen 11 und 12 in Abhängigkeit von den Rückwirkungen auf die Gradientenfelder durch diese Wirbelströme und magnetische Sättigungseffekte vorgesehen. In der praktischen Ausführungsform können die Gradientenspulen 11 und 12 beispielsweise jeweils aus zwei spiegelsymmetrisch zueinander angeordneten Segmenten bestehen, in Figur 2 sind sie jedoch zur Vereinfachung lediglich jeweils als einzelne Windung angedeutet. Diesen gegensinnig in Reihe geschalteten Gradientenspulen 11 und 12 ist jeweils eine Sensorspule 13 bzw. 14 zugeordnet, die in der Figur ebenfalls lediglich als einzelne Windung angedeutet und ebenfalls gegensinnig in Reihe geschaltet sind. Den beiden Gradientenspulen 11 und 12 ist ein gemeinsamer Regelkreis zugeordnet, der einen Regler 30 enthält, dem ein Meßwert Mₗ als Istwert der Regelabweichung über einen Subtrahierer 32 vorgegeben ist. Als Führungsgröße S des Regelkreises kann vorzugsweise eine Pulsfolge, die sogenannte Pulssequenz, mit etwa trapezförmigen Impulsen vorgesehen sein, deren Amplitude den Sollwert der Regelung bestimmt. Diese Führungsgröße S wird dem Subtrahierer 32 über einen Hochpaß 34 zugeführt und den Meßwert Mₗ erhält der Subtrahierer 32 von einem Tiefpaß 36, der die an den Sensorspulen 13 und 14 als Istwert aufgenommene Flußänderung dφ/dt in den Meßwert Mₗ umwandelt, der oberhalb einer Grenzfrequenz fᵤ dem Magnetfluß φ proportional ist. Dem Regler 30 ist ein Addierer 38 nachgeschaltet, dessen zweitem Eingang die Führungsgröße S ungeregelt direkt vorgegeben wird. Das Ausgangssignal des Addierers 38 wird einer spannungsgeregelten Stromquelle PSU (power supply unit) für den Gradientenstrom I_{G} der Gradientenspulen 11 und 12 zugeführt. Diese Stromquelle ist in der Figur mit 40 und ein Widerstand im Rückkopplungszweig der Stromquelle mit 42 bezeichnet. Unter Umständen kann es zweckmäßig sein, die Führungsgröße S dem Regelkreis über einen Tiefpaß 44 zuzuführen.

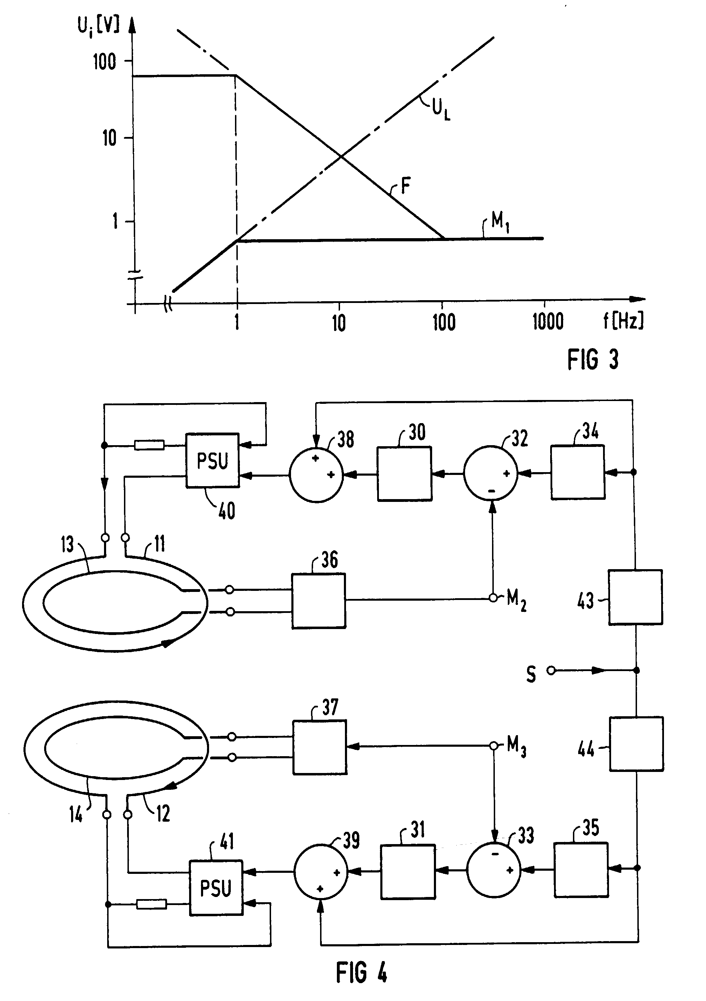

Gemessen wird an den Sensorspulen 13 und 14 gemäß dem Diagramm der Figur 3, in dem die in den Sensorspulen 13 und 14 induzierte Spannung Uᵢ in Volt in logarithmischem Maßstab über der Frequenz f in Hz ebenfalls in logarithmischem Maßstab aufgetragen ist, die Leerlaufspannung U_{L}. Diese Leerlaufspannung U_{L} ist an den Sensorspulen 13 und 14 nicht dem Fluß φ, sondern der Flußänderung dφ/dt proportional, so daß die Amplitude der Leerlaufspannung U_{L} linear mit der Frequenz f zunimmt. Erforderlich für den Regelkreis ist jedoch ein Meßwert M, der dem Fluß φ proportional ist. Es ist deshalb ein Tiefpaß 36 mit einer Übertragungsfunktion F ∼ l/f oberhalb einer unteren Grenzfrequenz fᵤ von beispielsweise 1 Hz vorgesehen. Der Tiefpaß 36 wirkt oberhalb der Grenzfrequenz fᵤ als Integrator und liefert ein Meßsignal Mₗ, das dem Fluß φ proportional ist und gemäß Figur 2 dem Subtrahierer 32 vorgegeben ist. Unterhalb der Grenzfrequenz fᵤ ist eine Regelung nicht erforderlich, es wird somit über den zum Tiefpaß 36 komplementären Hochpaß 34 auch nur ein Sollwert vorgegeben, der denselben hochpaßartigen Frequenzgang wie das Meßsignal Mₗ aufweist. Durch diese Maßnahme braucht für die Umwandlung der Flußänderung dφ/dt in den Fluß φ kein echter Integrator eingesetzt zu werden, der bekanntlich bei der Frequenz f = 0 Hz instabil ist (Driftproblem). Zur Begrenzung der maximal möglichen Flankensteilheit kann für die Führungsgröße S noch ein Tiefpaß 44 mit einer oberen Grenzfrequenz von beispielsweise fₒ = 5 kHz vorgesehen sein. Der Subtrahierer 32 liefert dem Regler 30 eine Eingangsspannung, die proportional ist der Regelabweichung. Als Regler 30 kann beispielsweise ein Proportionalregler oder auch ein Proportional-Differentialregler vorgesehen sein, dessen Ausgangssignal im Addierer 38 mit dem Sollwert addiert wird. Die spannungsgesteuerte Stromquelle 40 wandelt ihre Eingangsspannung um in einen proportionalen Gradientenstrom I_{G}, mit dem die Gradientenspulen 11 und 12 versorgt werden.

Der Tiefpaß 36 wirkt oberhalb der Grenzfrequenz fᵤ als Integrator und wirkt reziprok zum Hochpaß 34, der die Führungsgröße S mit demselben Frequenzgang wie das Meßsignal M liefert.

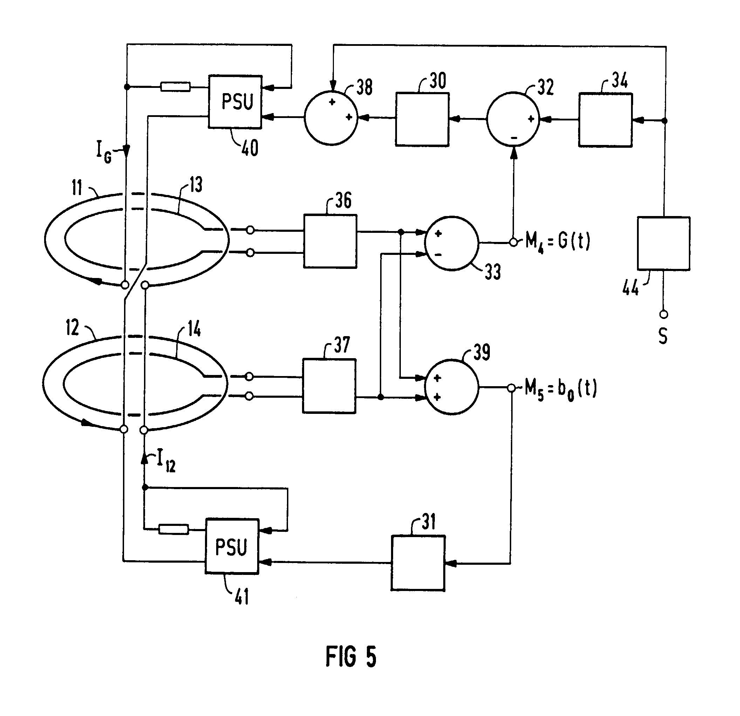

Für die Regelung des Gradienten G_{z}, der an einer der Polplatten, beispielsweise in der Darstellung gemäß Figur 1 an der Polfläche 7, mit dem Grundfeld B_{O} gleichgerichtet und an der anderen Polplatte, beispielsweise an der Polfläche 8, dem Grundfeld B_{O} entgegengerichtet ist, kann gemäß Figur 4 vorzugsweise jeweils eine getrennte Erfassung des Magnetflusses φ und jeweils ein getrennter Regelkreis für die beiden Gradientenspulen 11 und 12 vorgesehen sein. In dieser Ausführungsform sind die beiden gegensinnig in Reihe geschalteten Gradientenspulen 11 und 12 jeweils an eine spannungsgesteuerte Stromquelle 40 bzw. 41 angeschlossen, deren Eingangsspannung jeweils von einem Regelkreis mit einem Regler 30 bzw. 31 geliefert wird. Die Sensorspulen 13 und 14 sind jeweils an einen Tiefpaß 36 bzw. 37 angeschlossen, deren Eingangssignal der Magnetflußänderung dφ/dt und deren Ausgangssignal oberhalb der Grenzfrequenz fᵤ dem Magnetfluß φ proportional ist, die als Meßwerte M₂ bzw. M₃ dem zugeordneten Regelkreis zugeführt werden. Diese Meßwerte M₂ und M₃ dienen jeweils als Istwert für die Regelabweichung. In dieser Ausführungsform kann den Regelkreisen eine gemeinsame Führungsgröße S als Pulssequenz vorgegeben sein. Die Führungsgröße S kann vorzugsweise jeweils über einen Tiefpaß 43 bzw. 44 sowie einen Hochpaß 34 bzw. 35 und einen Subtrahierer 32 bzw. 33 dem zugeordneten Regler 30 bzw. 31 zugeführt werden. Die Führungsgröße S wird jeweils einem Addierer 38 bzw. 39 direkt vorgegeben. In dieser Ausführungsform können sowohl Bildstörungen, die von den Wirbelströmen in den Polplatten verursacht werden, als auch Bildstörungen, die von den transienten Rückwirkungen bₒ(t) auf das Grundfeld aufgrund von magnetischen Nichtlinearitäten verursacht werden, ausgeregelt werden.

In einer weiteren Ausführungsform der Flußregelung mit getrennten Regelkreisen für den Gradienten G_{z} gemäß Figur 5 sind die beiden Gradientenspulen 11 und 12 gegensinnig in Reihe geschaltet und an die gemeinsame spannungsgesteuerte Stromquelle 40 angeschlossen. Für die Gradientenspule 12 ist noch eine zusätzliche spannungsgesteuerte Stromquelle 41 vorgesehen, deren Eingangsspannung von dem zusätzlichen Regler 31 geliefert wird. Der Sensorspule 13 ist ein Regelkreis zugeordnet, der im wesentlichen der Ausführungsform gemäß Figur 2 entspricht, den Tiefpässen 36 und 37 ist jedoch noch ein Subtrahierer 33 und ein Addierer 39 nachgeschaltet. In dieser Ausführungsform der Flußregelung werden die Summe und die Differenz der magnetischen Flüsse in jedem der Teilsysteme geregelt. Für die beiden Gradientenspulen 11 und 12 ist eine Stromquelle 40 der üblichen Leistungsklasse vorgesehen, welche den Gradientenstrom I_{G} für die beiden Gradientenspulen 11 und 12 liefert. Parallelgeschaltet ist die weitere Stromquelle 41 wesentlich geringerer Leistung, deren Strom I₁₂ nur die Gradientenspule 12 durchfließt, da die gesteuerte Stromquelle 40 theoretisch einen unendlich hohen Innenwiderstand hat. Die von den Sensorspulen 13 und 14 aufgenommenen Leerlaufspannungen U_{L} werden wie in der Ausführungsform gemäß Figur 2 zunächst integriert, damit sie die magnetischen Teilflüsse in den Sensorspulen 13 und 14 repräsentieren und dann addiert und subtrahiert. Am Ausgang des Subtrahierers 33 erhalt man somit die Änderung des Gradienten G(t) als Meßsignal M₄, das der Differenz der Magnetflüsse φ₁₃-φ₁₄ proportional ist und dem Regler 30 als Istwert zugeführt wird. Die Stromquelle 40 liefert dann den geregelten Gradientenstrom I_{G} für den Nutzgradienten in der üblichen Größe. Die Summe der Magnetflüsse φ₁₃ + φ₁₄ am Ausgang des Addierers 39 bildet ein Maß für Bildstörungen, die durch eine transiente Absenkung des Grundfeldes bₒ(t) verursacht werden. Nur dieser Störeffekt wird von dem zusätzlichen Addierer 39 als Meßwert M₅ geliefert, welcher der Summe der Magnetflüsse φ₁₃ + φ₁₄ proportional ist und über den Regler 31 der Stromquelle 41 als Eingangsspannung vorgegeben wird. Die Anforderungen an die Aussteuerbarkeit der Stromquelle 41 sind somit im allgemeinen wesentlich kleiner als die Anforderungen an die Aussteuerbarkeit der Stromquelle 40.

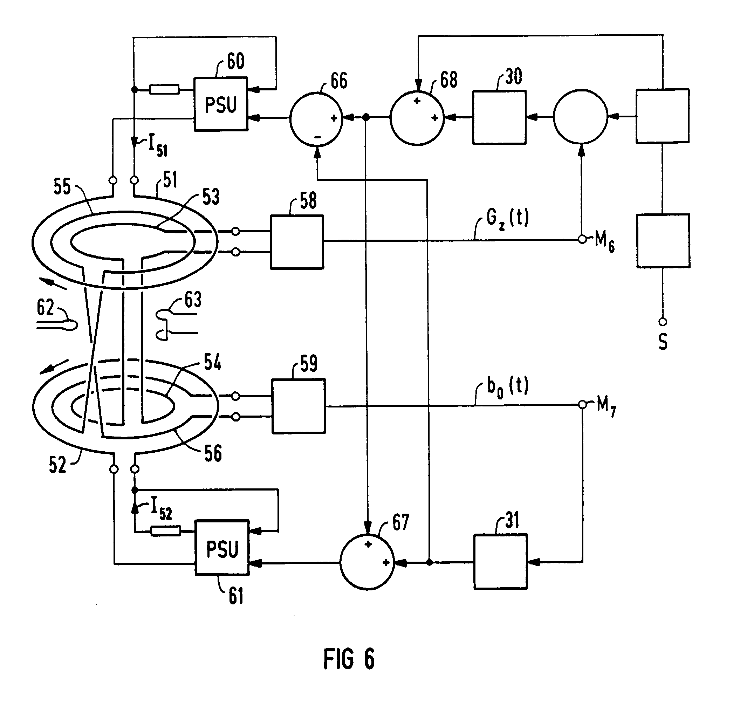

In einer besonders vorteilhaften Ausgestaltung des Kernspintomographen gemäß Figur 6 ist für den Gradienten G_{z}(t) und für den dynamischen Grundfeldhub bₒ(t) jeweils ein eigenes Sensorspulensystem vorgesehen. Die beiden Gradientenspulen 51 und 52 für den Gradienten G_{z} sind von gegensinnigen Strömen durchflossen und jeweils an eine spannungsgesteuerte Stromquelle 60 bzw. 61 angeschlossen. Die Eingangsspannungen dieser beiden Stromquellen werden jeweils von einem geschlossenen Regelkreis mit dem Regler 30 bzw. 31 geliefert. Den Gradientenspulen 51 und 52 ist jeweils eine Sensorspule 53 bzw. 54 zugeordnet, die gegensinnig in Reihe geschaltet und an einen gemeinsamen Tiefpaß 58 angeschlossen sind, der oberhalb einer unteren Grenzfrequenz fᵤ als Integrator wirkt. Das Ausgangssignal dieses Tiefpasses 58 ist proportional dem Gradienten G_{z}(t) und wird als Meßsignal M₆ über den Regelkreis mit dem Regler 30 beiden Stromquellen 60 und 61 mit gleichem Vorzeichen vorgegeben. Den beiden Gradientenspulen 51 und 52 ist jeweils noch eine zusätzliche Sensorspule 55 bzw. 56 zugeordnet, die gleichsinnig in Reihe geschaltet sind und ebenfalls an einen gemeinsamen Tiefpaß 59 angeschlossen sind, der oberhalb einer unteren Grenzfrequenz fᵤ als Integrator wirkt. Das Ausgangssignal dieses Tiefpasses 59 ist proportional dem Grundfeldhub bₒ(t) und wird als Meßsignal M₇ über den zweiten Regelkreis mit dem Regler 31 mit positivem Vorzeichen der Stromquelle 61 für den Gradientenstrom I₅₂ der zweiten Gradientenspule 52 und mit negativem Vorzeichen der Stromquelle 60 des Gradientenstromes I₅₁ der ersten Gradientenspule 51 zugeführt. Diese Sensorspulen 53 und 54 sowie 55 und 56 können mit ihrem Durchmesser und gegebenenfalls auch mit ihrer Windungszahlverteilung unabhängig voneinander so dimensioniert werden, daß sie jeweils möglichst rein und repräsentativ den jeweiligen Feldtyp liefern.

Mit einer die Flußdichte lokal messenden zusätzlichen Magnetfeldsonde 62 mit verhältnismäßig kleinem Durchmesser kann vorzugsweise bei niedriger Frequenz des Gradientenfeldes der örtliche Nulldurchgang des Gradientenfeldes für den Gradienten G_{z} im Magnetzentrum ermittelt und als Nullpunkt der z-Koordinate des Koordinatensystems bestimmt werden. In dieser Position liefert die Magnetfeldsonde 62 nach zeitlicher Integration nur den Grundfeldhub bₒ(t) zu Kontrollzwecken.

Der Nulldurchgang des Gradientenfeldes kann gegebenfalls auch mit einer anderen Magnetfeldsonde, beispielsweise mit einer Hall-Sonde, bei stationär eingeschaltetem Gradienten G_{z} ermittelt werden.

Zur optimalen Auslegung der Sensorspulen 55 und 56 zur Detektion des dynamischen Grundfeldhubs bₒ(t) kann vorzugsweise eine größere Anzahl solcher axialsymmetrischen Sensorspulen auf jeder der Polflächen 7 und 8 mit unterschiedlichem Radius Rₖ eingesetzt werden, beispielsweise k = 1;5. Dann werden jeweils von den Sensorspulen an der oberen Polfläche 7 und den Sensorspulen der unteren Polfläche 8 diejenigen mit gleichem Radius Rₖ gleichsinnig derart miteinander verbunden, daß sie ein Grundfeld Bₒ detektieren. Für die Gradientenströme I₅₁ und I₅₂ in den z-Gradientenspulen wird nun ein Einheitssprung δ₋₁(t) gewählt. Die dazugehörige Sprungantwort ^{z}bₒ(t) der Sondenspule 62 wird mit den verschiedenen Antworten ^{z}b_{o,k}(t) der verschiedenen Sensorspulen mit den Radien Rₖ verglichen. Der linke, obere Index z gibt das vom Strom durchflossene Gradientensystem an. Für den bₒ(t)-Zweig der Regelung können dann diejenigen Sensorspulen aus der Vielzahl dieser Spulen gewählt werden, deren Sprungantwort ^{z}bₒ,ₘ(t) am besten mit dem von der Sondenspule 62 zentral gemessenen Grundfeldhub ^{z}bₒ(t) übereinstimmt.

Es können jedoch auch die Wichtungsfaktoren in einer gewichteten Summe über die Antworten ^{z}b_{o,k}(t) so gewählt werden, daß die Summe möglichst gut mit dem zentral gemessenen dynamischen Grundfeldhub ^{z}bₒ(t) übereinstimmt. Die Wichtungsfaktoren lassen sich durch entsprechende Wahl der Windungszahlen N_{K} bei den Radien R_{K} annähern.

Zur Auslegung der Sensorspulen 53 und 54 für den Gradienten G_{z} werden diese Sensorspulen auf den Polflächen 7 bzw. 8 gegensinnig miteinander so verbunden, daß sie ein Gradientenfeld G_{z},ₖ(t) detektieren. Dazu kann eine lokal messende, gegensinnig gepolte Differenzspule 63 als Sonde für die Detektion des Gradientenfeldes G_{z}(t) im Zentrum des Gradientenfeldes vorgesehen sein, welche zugleich die erzeugten Feldbeiträge des Grundfeldhubes unterdrückt. Man vergleicht die Antwort G_{z}(t) der zentralen Differenzspule 63 mit den verschiedenen sprungantworten G_{z},ₖ(t) der Sensorspulen auf einen Einheitssprung δ₋₁(t) der Gradientenströme I₅₁ und I₅₂ und wählt dann diejenigen Spulenpaare aus den Sensorspulen 53 und 54 oder eine Kombination, deren Sprungantwort am besten mit dem zentral gemessenen Wert übereinstimmt.

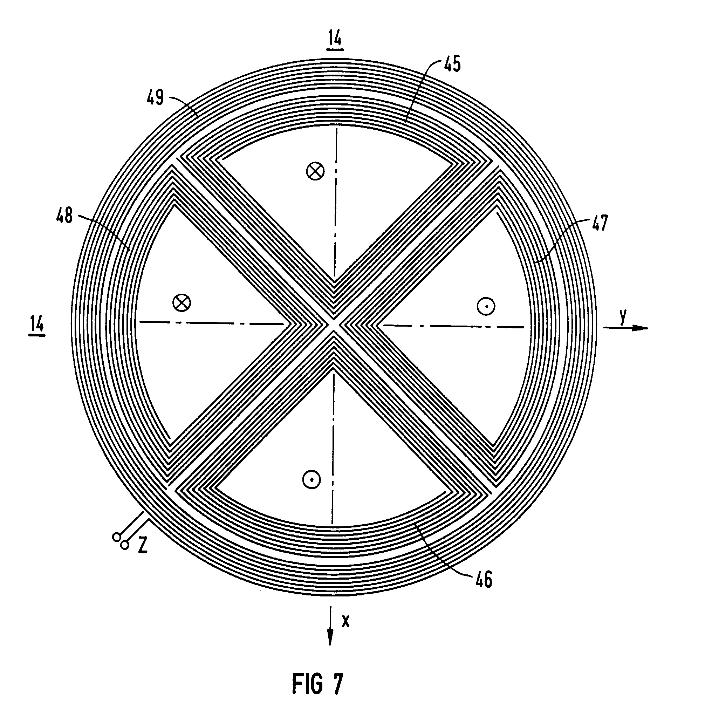

In einer besonders vorteilhaften Ausführungsform der Flußregelung der Gradientenfelder des Kernspintomographen können die Polschuhe 3 und 4 jeweils mit einer Kombination von Sensorspulen 13 bzw. 14 versehen sein, die das Spulensystem als gemeinsame Flachspule bilden, die parallel zu einer der Polflächen 7 und 8 angeordnet ist. In dieser Ausführungsform beispielsweise der Sensorspule 14 sind gemäß Figur 7 zwei Teilspulen 45 und 46 für den Gradienten Gₓ jeweils als Kreissektor ausgebildet und derart angeordnet, daß ihre spitzen einander entgegengerichtet sind. Die Richtung des Gradientenfeldes ist in der Figur durch einen Richtungspunkt und einen Richtungspfeil angedeutet. In gleicher Weise sind zwei weitere Teilspulen 47 und 48 für den Gradienten G_{y} als Kreissektoren ausgebildet und gegenüber den Teilspulen 45 und 46 um 90° verdreht in der gleichen Ebene derart angeordnet, daß sie alle gemeinsam etwa eine Kreisfläche bilden. Diese Teilspulen 45 bis 48 sind von einer Spule 49 umgeben, deren Windungen eine Kreisringfläche bilden und als Sensor für den Gradienten G_{z} dienen. Die in der Figur angedeuteten elektrischen Anschlüsse für die Sensorspule 49 sind in der Figur lediglich mit z bezeichnet. Die Teilspulen 45 bis 48 werden derart angeschlossen und miteinander verbunden, daß sie die Gradientenflüsse mit der angegebenen Richtung erfassen. Diese Verbindungsleiter sind zur Vereinfachung in dem Spulensystem nicht dargestellt.

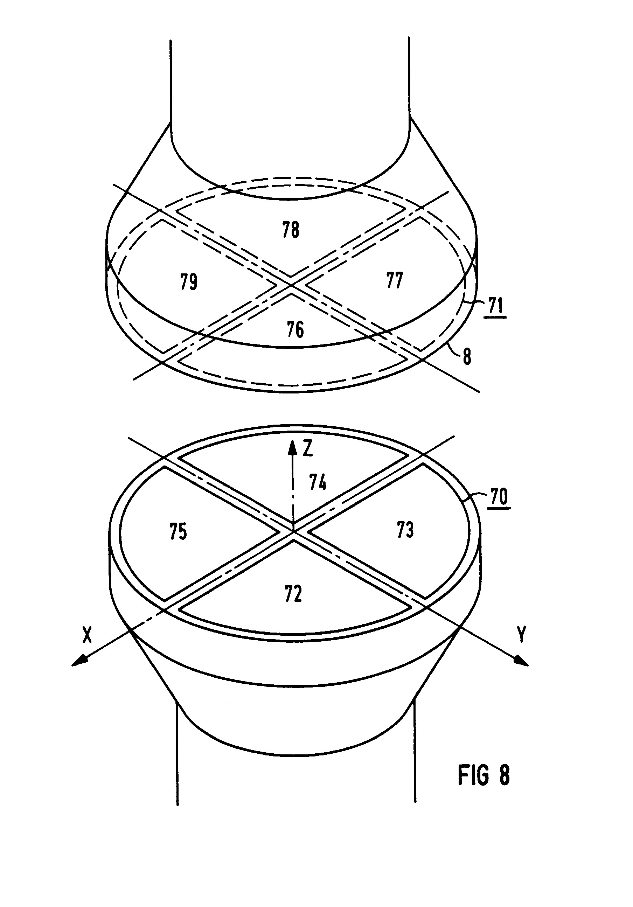

In einer besonders vorteilhaften Ausführungsform des Kernspintomographen gemäß Figur 8 ist ein gemeinsames Sensorspulensystem vorgesehen für die Gradienten Gₓ, G_{y} und G_{z} und den dynamischen Grundfeldhub bₒ(t). Das Spulensystem enthält zwei Flachspulen 70 und 71, die jeweils auf einer der Polflächen 7 bzw. 8 angeordnet sind. Diese Flachspulen 70 und 71 bestehen jeweils aus vier Teilspulen 72 bis 75 bzw. 76 bis 79, die jeweils etwa einen Kreisflächensektor der Polflächen 7 und 8 mit einem Öffnungswinkel von 90° bilden. Von diesen Teilspulen sind jeweils zwei, beispielsweise 72 und 76, die in Richtung des Grundfeldes Bₒ, d.h. in z-Richtung, an den Polflächen 7 und 8 übereinander angeordnet sind, gleichsinnig in Reihe geschaltet, am Verbindungspunkt an Masse gelegt und mit einer elektronischen Vorzeichengewichtung versehen. Es erscheinen deshalb die Meßwerte Mₓ, M_{y} und M_{z} für die entsprechenden Gradientenfelder und vorzugsweise auch noch ein Meßwert M_{bo} zur Ausregelung der dynamischen Grundfeldstörungen an den zugehörigen Ausgängen der Elektronik. Durch diese elektronische Vorzeichengewichtung wird unter Beibehaltung einer einlagigen Sensorspulen-Ausführung mit den beiden Flachspulen 70 und 71 wenigstens annähernd jeweils der magnetische Fluß der gesamten Polfläche erfaßt. Da gegenüber der Ausführungsform gemäß Figur 7 auch noch die äußere Sensorspule 49 für den Gradienten G_{z} entfällt, können unter Beibehaltung des ursprünglichen Außendurchmessers die vier Teilspulen 72 bis 75 und 76 bis 79 entsprechend mehr Windungen enthalten, was einen weiteren Spannungsgewinn bedeutet.

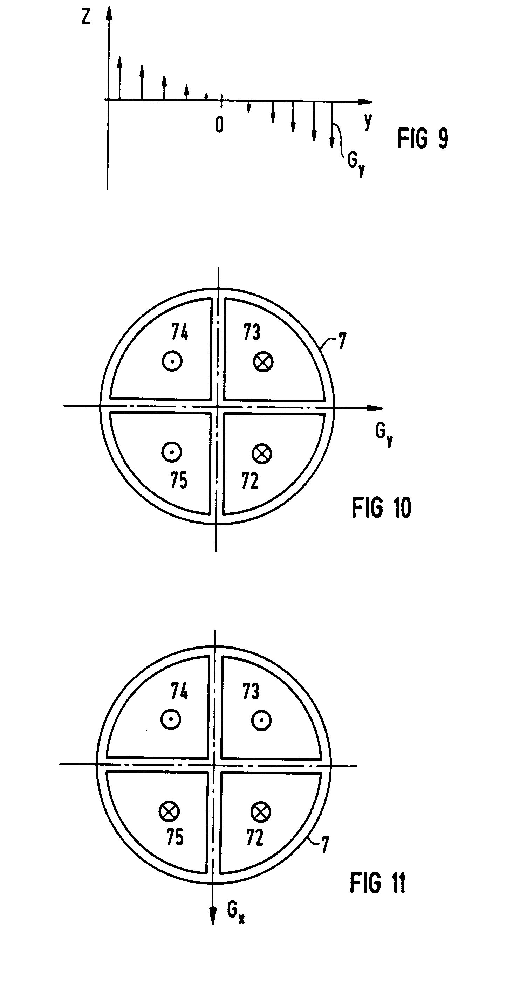

In dieser Ausführungsform werden vorzugsweise jeweils die beiden spiegelbildlich zur Gradientenrichtung angeordneten Teilspulen mit dem gleichen Vorzeichen gewichtet. Im Diagramm der Figur 9 sind beispielsweise die Feldvektoren des Gradientenfeldes G_{y} in Richtung des Grundfeldes B_{z} über der y-Richtung aufgetragen. Diese Vektoren haben auf der einen Hälfte der Polfläche 7 negative und auf der anderen Hälfte positive Richtung. Dementsprechend werden die beiden spiegelbildlich zur Richtung des Gradienten G_{y} angeordneten Teilspulen 72 und 73 bzw. 76 und 77 mit negativem Vorzeichen und die beiden Teilspulen 74 und 75 bzw. 78 und 79 mit positivem Vorzeichen gewichtet.

Somit werden gemäß Figur 11, in der ebenfalls die Anordnung der Teilspulen 72 bis 75 auf der Polplatte 7 dargestellt ist, die spiegelbildlich zur Richtung des Gradienten Gₓ angeordneten Teilspulen 72 und 75 mit negativem und die Teilspulen 73 und 74 mit positivem Vorzeichen gewichtet. Analog dazu werden die Teilspulen 76 und 79 mit negativem und die Teilspulen 77 und 78 mit positivem Vorzeichen gewichtet.

Für den Gradienten G_{z} werden alle Teilspulen 72 bis 79 der Flachspule 70 mit dem gleichen Vorzeichen gewichtet.

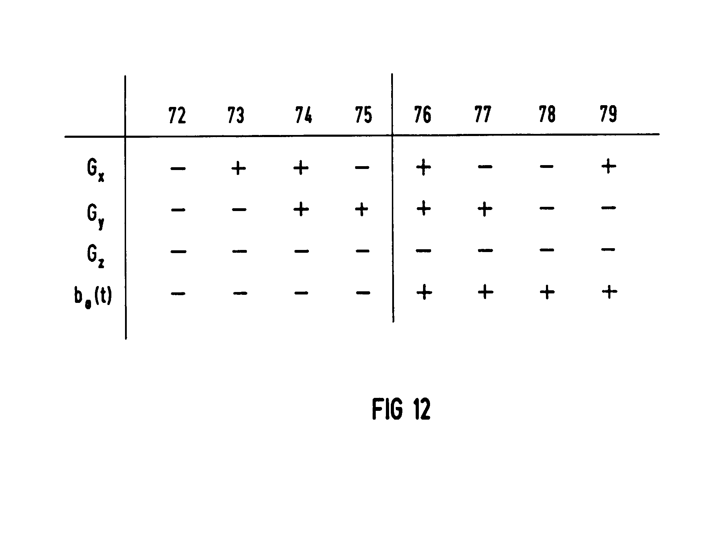

In einer besonders vorteilhaften Ausführungsform des Kernspintomographen liefern die Teilspulen der beiden Flachspulen 70 und 71 auch einen Beitrag für einen Meßwert M_{bo} zur Korrektur der dynamischen Störungen des Grundfeldes Bₒ, wobei hier gemäß der Tabelle in Figur 12 die Teilspulen 72 bis 75 mit zu den Teilspulen 76 bis 79 entgegengesetztem Vorzeichen gewichtet werden.

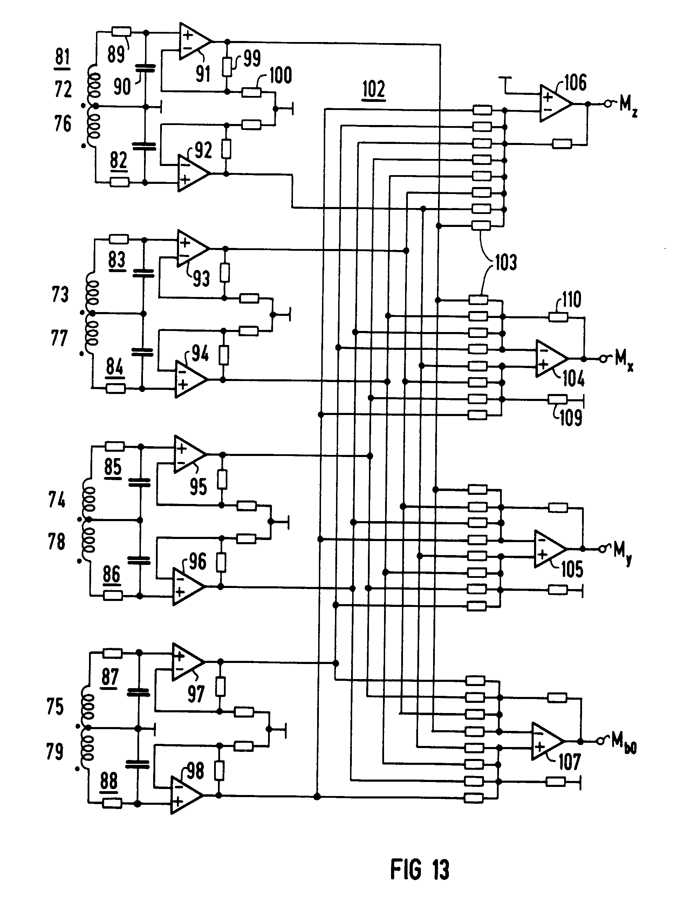

Eine Ausführungsform der Schaltung zur elektronischen Gewichtung des Anteils der einzelnen Teilspulen 72 bis 79 und die getrennte Erfassung der Meßwerte Mₓ, M_{y} und M_{z} sowie vorzugsweise auch des Meßwertes M_{bo} als Istwerte für die Regelung ist in Figur 13 schematisch dargestellt. Die Teilspulen 72 und 76, deren Wicklungsanfang jeweils durch einen Punkt dargestellt ist, sind in Reihe geschaltet. Ihre Ausgangssignale werden jeweils über einen Tiefpaß und einen Vorverstärker sowie eine Sammelleitung 102 und einen Summierwiderstand einem Operationsverstärker zugeführt, der einen Meßwert als Istwert für die Stromregelung liefert. Die Tiefpässe sind in der Schaltung mit 81 bis 88 bezeichnet und können vorzugsweise jeweils aus einer RC-Kombination mit einem Widerstand 89 und einem Kondensator 90 bestehen. Die Vorverstärker sind in der Figur mit 91 bis 98 bezeichnet; sie enthalten jeweils ein Gegenkopplungsnetzwerk bestehend aus den Widerständen 99 und 100. Die Beschaltungen der Wicklungen 72 bis 79 sind gleich und zur besseren Übersicht deshalb nicht näher bezeichnet. Die Operationsverstärker für die Meßwerte Mₓ, M_{y} und M_{z} sind in der Figur mit 104 bzw. 105 bzw. 106 bezeichnet und vorzugsweise kann auch noch ein weiterer Operationsverstärker 107 für den Meßwert M_{bo} zur Regelung des dynamischen Grundfeldhubs bₒ(t) vorgesehen sein.

Beispielsweise wird der Meßwert der Teilspule 72 über den Tiefpaß 81 und den Vorverstärker 91 sowie den Summierwiderstand 103 dem negativen Eingang des Operationsverstärkers 104 zugeführt, der am Ausgang den Meßwert Mₓ für den Gradienten Gₓ liefert. Ein Gegenkopplungswiderstand des Operationsverstärkers 104 ist mit 110 bezeichnet. Ferner werden dem negativen Eingang des Operationsverstärkers 104 gemäß der Tabelle in Figur 12 die Meßwerte der Teilspulen 75 sowie 77 und 78 zugeführt. Der positive Eingang des Operationsverstärkers 104 erhält gemäß der Tabelle in Figur 12 die Signale der Teilspulen 73, 74, 76 und 79. In gleicher Weise bildet der Operationsverstärker 105 an seinem Ausgang den Meßwert M_{y} als Istwert für die Regelung des Gradienten G_{y} aus den Signalanteilen der Teilspulen 72, 73, 78 und 79 mit negativer Gewichtung und den Signalanteilen der Teilspulen 74, 75, 76 und 77 mit positiver Gewichtung. Der Operationsverstärker 106 erhält die Signalanteile aller acht Teilspulen 72 bis 79 an seinem negativen Eingang und liefert am Ausgang den Meßwert M_{z} für den Gradienten G_{z}. Der Operationsverstärker 107 für den Meßwert M_{bo} zur Regelung der dynamischen Störungen des Grundfeldes Bₒ erhält die Signale der Teilspulen 72 bis 75 an seinem negativen und die Signale der Teilspulen 76 bis 79 an seinem positiven Eingang.

Die Regelung der Gradientenfelder 72 bis 79 erfolgt nur oberhalb der Grenzfrequenz der Tiefpässe 81 bis 88, d.h. gemäß dem Diagramm der Figur 1 nur oberhalb etwa 1 Hz, da unterhalb dieser Grenzfrequenz die Regelung weder erforderlich noch sinnvoll ist. Die betreffende Teilspule und der zugeordnete Tiefpaß haben oberhalb der Tiefpaßgrenzfrequenz gegenläufige Frequenzgänge, so daß man ein Ausgangssignal erhält, das unabhängig ist von der Frequenz. In dieser Ausführungsform des Kernspintomographen sind alle acht Teilspulen beteiligt an der Erfassung des Meßwertes für jeden der Gradienten Mₓ, M_{y} und M_{z} sowie für den dynamischen Grundfeldhub bₒ(t). Zur Meßwerterfassung wird somit nahezu die gesamte Polfläche ausgenutzt.

## Patentansprüche

1. Kernspintomograph zur Untersuchung eines menschlichen Körpers, dessen Körperachse sich in Richtung der x-Achse eines rechtwinkligen Koordinatensystems erstreckt und dessen zu untersuchender Körperbereich sich zwischen den mit jeweils wenigstens einer Gradientenspule versehenen ebenen Polflächen eines Grundfeldmagneten befindet, dessen magnetisches Grundfeld B_{O} sich in Richtung der z-Achse erstreckt, **dadurch gekennzeichnet,** daß die Gradientenspulen (11, 12) gegensinnig in Reihe geschaltet und an eine spannungsgesteuerte Stromquelle (40) angeschlossen sind, deren Eingangsspannung von einem Regler (30) mit nachgeschaltetem Addierer (38) vorgegeben ist und deren Gradientenstrom I_{G} als Stellgröße für eine Regelung des Magnetflusses φ der Gradientenspulen (11, 12) in Abhängigkeit von Rückwirkungen auf den Magnetfluß φ, die durch Wirbelströme und Sättigungseffekte im ferromagnetischen Material in der Nähe der Polflächen (7, 8) verursacht sind, vorgesehen ist, und daß den Gradientenspulen (11, 12) zum Erfassen des als Regelgröße vorgesehenen Magnetflusses φ jeweils eine Sensorspule (13, 14) zugeordnet ist, deren Leerlaufspannung U_{L} als Eingangssignal für einen Tiefpaß (36) vorgesehen ist, der oberhalb einer unteren Grenzfrequenz fᵤ als Integrator wirkt und dessen Ausgangssignal oberhalb der Grenzfrequenz fᵤ als dem Magnetfluß φ proportionaler Meßwert Mₗ für den Regler (30) vorgesehen ist (Figuren 2 und 3).

2. Kernspintomograph nach Anspruch 1, **dadurch gekennzeichnet,** daß den Gradientenspulen (11, 12) für den Gradienten Gₓ und den Gradienten G_{y} jeweils ein gemeinsamer Regelkreis zugeordnet ist (Figur 2).

3. Kernspintomograph nach Anspruch 1, **dadurch gekennzeichnet,** daß die Führungsgröße S für die Regelung dem Regelkreis über einen zum Tiefpaß (36) komplementären Hochpaß (34) vorgegeben ist und daß die Regelabweichung über den Regler (30) der Stromquelle (40) als Steuerspannung vorgegeben ist (Figur 2).

4. Kernspintomograph nach Anspruch 1, **dadurch gekennzeichnet,** daß einem zweiten Eingang des Addierers (38) die Führungsgröße S für die Regelung direkt vorgegeben ist (Figur 2).

5. Kernspintomograph nach Anspruch 1, **gekennzeichnet** durch eine zusätzliche Regelung des dynamischen Grundfeldhubs bₒ(t) über die Gradientenspulen.

6. Kernspintomograph nach Anspruch 5, **dadurch gekennzeichnet,** daß den beiden Gradientenspulen (11, 12) für den Gradienten G_{z} jeweils ein getrennter Regelkreis zugeordnet ist (Figur 4).

7. Kernspintomograph nach Anspruch 6, **dadurch gekennzeichnet,** daß die Gradientenspulen (11, 12) an eine gemeinsame spannungsgesteuerte Stromquelle (40) angeschlossen sind, und daß den Sensorspulen (13, 14) jeweils ein Tiefpaß (36, 37) zugeordnet ist, deren Ausgangssignale einem Addierer (39) und einem Subtrahierer (33) vorgegeben sind, und daß das Ausgangssignal des Subtrahierers (33) als Meßsignal M₄ für den Regler (30) und das Ausgangssignal des Addierers (39) als Meßsignal M₅ über einen zusätzlichen Regler (31) einer zusätzlichen spannungsgesteuerten Stromquelle (41) für eine der Gradientenspulen (11) als Eingangssignal vorgegeben ist (Figur 5).

8. Kernspintomograph nach Anspruch 6, **dadurch gekennzeichnet,** daß die beiden Gradientenspulen (51, 52) für den einen der Gradienten (Gradienten G_{z} in Figur 6) von gegensinnigen Gradientenströmen (I₅₁, I₅₂) durchflossen sind und jeweils an eine spannungsgesteuerte Stromquelle (60, 61) angeschlossen sind, deren Eingangsspannung von einem Subtrahierer (66) bzw. Addierer (67) vorgegeben ist, und daß für die Regelung des Gradienten diesen Gradientenspulen (51, 52) jeweils eine zusätzliche Sensorspule (53, 54) zugeordnet ist, die gegensinnig in Reihe geschaltet und an einen Tiefpaß (58) angeschlossen sind, der oberhalb einer unteren Grenzfrequenz (fᵤ) als Integrator wirkt, und dessen Meßsignal (M₆) als Istwert für einen Regler (30) des Regelkreises gleichsinnig auf die Gradientenströme (I₅₁ und I₅₂) des Gradienten (G_{z}) einwirkt, und daß den Gradientenspulen (51, 52) für die Regelung des dynamischen Grundfeldhubs bₒ(t) jeweils eine weitere Sensorspule (55, 56) zugeordnet ist, die gleichsinnig in Reihe geschaltet sind und an einen Tiefpaß (59) angeschlossen sind, der oberhalb einer unteren Grenzfrequenz (fᵤ) als Integrator wirkt, und dessen dem dynamischen Grundfeldhub bₒ(t) proportionales Meßsignal (M₇) als Istwert für einen Regler (31) vorgesehen ist und mit unterschiedlichem Vorzeichen auf die beiden Gradientenströme (I₅₁ und I₅₂) einwirkt (Figur 6).

9. Kernspintomograph nach Anspruch 8, **dadurch gekennzeichnet,** daß zur Auslegung der Sensorspulen (55, 56) für den dynamischen Grundfeldhub bₒ(t) auf beiden Polflächen (7, 8) jeweils mehrere axialsymmetrisch angeordnete Sensorspulen mit verschiedenen Radien Rₖ vorgesehen sind, von denen jeweils diejenigen mit gleichem Radius Rₖ gleichsinnig miteinander verbunden sind, so daß Paare entstehen, aus denen eine günstige Kombination ausgewählt wird, deren resultierendes Signal am besten mit dem im Magnetfeldzentrum mittels beispielsweise einer Sonde des magnetischen Homogenfeldes gemessenen Grundfeldhub bₒ(t) übereinstimmt (Figur 6).

10. Kernspintomograph nach Anspruch 8, **dadurch gekennzeichnet,** daß zur Auslegung der Sensorspulen (53, 54) für einen der Gradienten auf beiden Polflächen (7, 8) jeweils mehrere Sensorspulen mit verschiedenen Radien Rₖ axialsymmetrisch angeordnet sind, von denen jeweils diejenigen mit gleichem Radius Rₖ gegensinnig miteinander verbunden sind, so daß Paare entstehen, aus denen eine günstige Kombination ausgewählt wird, deren resultierendes Signal am besten mit dem im Magnetzentrum mittels beispielsweise einer Differenzspule gemessenen Gradientenfeld Übereinstimmt (Figur 6).

11. Kernspintomograph nach einem der Ansprüche 1 bis 10, **gekennzeichnet** durch eine Kombination der Sensorspulen für die Gradienten Gₓ, G_{y} und G_{z}als zwei Flachspulen, von denen jeweils eine auf einer der Polflächen (7, 8) angeordnet sind.

12. Kernspintomograph nach Anspruch 11, **dadurch gekennzeichnet**, daß die Sensorspulen für den Gradienten Gₓ aus zwei Teilspulen (45, 46) bestehen, die jeweils einen Kreisflächensektor bilden, deren Spitzen einander entgegengerichtet sind, und daß die Sensorspulen für den Gradienten G_{y} ebenfalls aus zwei Teilspulen (47, 48) bestehen, die jeweils einen Kreisflächensektor bilden, deren Spitzen einander entgegengerichtet sind, und daß die beiden Teilspulen (45, 46) für den Gradienten Gₓ gegenüber den Teilspulen (47, 48) für den Gradienten G_{y} um 90° verdreht sind und daß diese Teilspulen von einer ringscheibenförmigen Sensorspule (49) für den Gradienten G_{z} umgeben sind (Figur 7).

13. Kernspintomograph nach Anspruch 11, **dadurch gekennzeichnet,** daß jede der Flachspulen (70, 71) aus vier Teilspulen (72, 73, 74, 75 bzw. 76, 77, 78, 79) besteht, die jeweils etwa einen Kreisflächensektor einer Polfläche (7 bzw. 8) mit einem Öffnungswinkel von 90° bilden und von denen jeweils zwei (72, 76; 73, 77; 74, 78; 75, 79) in Richtung des Grundfeldes Bₒ an den Polflächen (7, 8) übereinander angeordnet und gleichsinnig in Reihe geschaltet sind, und daß diese Teilspulen (72 bis 79) mit einer elektronischen Vorzeichengewichtung versehen sind (Figuren 8 bis 12).

14. Kernspintomograph nach Anspruch 13, **dadurch gekennzeichnet,** daß die beiden gleichsinnig in Reihe geschalteten Teilspulen (72, 76; 73, 77; 74, 78; 75, 79) jeweils über einen Tiefpaß (81 bis 88) und einen eigenen Vorverstärker (91 bis 98) zugehörige Ausgangssignale (102) liefern, welche für die Meßwerte (Mₓ, M_{y}, M_{z} und M_{bo}) derart an einen Operationsverstärker (104 bis 107) angeschlossen sind, daß das Ausgangssignal für die spiegelsymmetrisch zu den Gradienten Gₓ und G_{y} angeordneten Teilspulen (72, 75, 77, 78 und 73, 74, 76, 79 für Gₓ; 72, 73, 78, 79 und 74, 75, 76, 77 für G_{y}) mit unterschiedlichem Vorzeichen und für den Gradienten G_{z} alle Teilspulen (72 bis 79) jeweils einer der beiden Flachspulen (70, 71) mit dem gleichen Vorzeichen gewichtet werden (Figuren 9 bis 13).

15. Kernspintomograph nach Anspruch 13, **dadurch gekennzeichnet,** daß für die Regelung des dynamischen Grundfeldhubs b_{O}(t) eine elektronische Gewichtung der Teilspulen (72 bis 75) der einen Polfläche (7) mit entgegengesetztem Vorzeichen zu den Teilspulen (76 bis 79) der anderen Polfläche (8) vorgesehen ist (Figuren 12 und 13).

## Claims

1. Nuclear spin tomograph for examining a human body, the body axis of which extends in the direction of the x-axis of a rectangular system of coordinates and the body region of which that is to be examined is situated between the planar pole faces of a main field magnet, which pole faces are each provided with at least one gradient coil, and the magnetic main field B_{O} of which main field magnet extends in the direction of the z-axis, characterised in that the gradient coils (11, 12) are series-connected in opposite directions and are connected to a voltage-controlled power supply unit (40), the input voltage of which is given by a controller (30) having a subsequently connected adder (38) and the gradient current I_{G} of which is provided as a adjustable variable for a control of the magnetic flux φ of the gradient coils (11, 12) as a function of reactions to the magnetic flux φ, which reactions are caused by eddy currents and saturation effects in the ferromagnetic material in the vicinity of the pole faces (7, 8), and in that allocated to the gradient coils (11, 12) for detecting the magnetic flux φ, which is provided as a controlled variable, is a respective sensor coil (13, 14), the no-load voltage U_{L} of which is provided as an input signal for a low-pass filter (36), which acts as an integrator above a lower cut-off frequency fᵤ, and the output signal of which is provided above the cut-off frequency fᵤ as a measured value M₁ for the controller (30), which measured value is proportional to the magnetic flux φ (Figures 2 and 3).

2. Nuclear spin tomograph according to claim 1, characterised in that allocated to the gradient coils (11, 12) for the gradient Gₓ and the gradient G_{y} is a respective common control circuit (Figure 2).

3. Nuclear spin tomograph according to claim 1, characterised in that the reference variable S for the control is given to the control circuit by way of a high-pass filter (34) which is complementary to the low-pass filter (36), and in that the control deviation is given to the power supply unit (40) as a control voltage by way of the controller (30) (Figure 2).

4. Nuclear spin tomograph according to claim 1, characterised in that the reference variable S for the control is given directly to a second input of the adder (38) (Figure 2).

5. Nuclear spin tomograph according to claim 1, characterised by an additional control of the dynamic main field lift bₒ(t) by way of the gradient coils.

6. Nuclear spin tomograph according to claim 5, characterised in that allocated to the two gradient coils (11, 12) for the gradient G_{z} is a respective separate control circuit (Figure 4).

7. Nuclear spin tomograph according to claim 6, characterised in that the gradient coils (11, 12) are connected to a common voltage-controlled power supply unit (40), and in that allocated to the sensor coils (13, 14) is a respective low-pass filter (36, 37), the output signals of which are given to an adder (39) and to a subtractor (33), and in that the output signal of the subtractor (33) as a measured signal M₄ for the controller (30), and the output signal of the adder (39) as a measured signal M₅, are given by way of an additional controller (31) to an additional voltage-controlled power supply unit (41) for one of the gradient coils (11) as an input signal (Figure 5).

8. Nuclear spin tomograph according to claim 6, characterised in that gradient currents (I₅₁, I₅₂) flowing in opposite directions flow through the two gradient coils (51, 52) for the one of the gradients (gradient G_{z} in Figure 6), which gradient coils are each connected to a voltage-controlled power supply unit (60, 61), the input voltage of which is given by a subtractor (66) or adder (67) respectively, and in that for the control of the gradient there is allocated to these gradient coils (51, 52) a respective additional sensor coil (53, 54), which sensor coils are series-connected in opposite directions and are connected to a low-pass filter (58) which acts as an integrator above a lower cut-off frequency (fᵤ), and the measured signal (M₆) of which, as an actual value for a controller (30) of the control loop, acts in the same direction on the gradient currents (I₅₁ and I₅₂) of the gradient (G_{z}), and in that allocated to the gradient coils (51, 52) for the control of the dynamic main field lift bₒ(t) is a respective further sensor coil (55, 56), which sensor coils are series-connected in the same direction and are connected to a low-pass filter (59) which acts as an integrator above a lower cut-off frequency (fᵤ), and the measured signal (M₇) of which, being proportional to the dynamic main field lift bₒ(t), is provided as an actual value for a controller (31) and acts on the two gradient currents (I₅₁ and I₅₂) with different polarity signs (Figure 6).

9. Nuclear spin tomograph according to claim 8, characterised in that in order to design the sensor coils (55, 56) for the dynamic main field lift bₒ(t), there are provided on both pole faces (7, 8) in each case a plurality of sensor coils arranged axial-symmetrically and having various radii Rₖ, of which sensor coils in each case those having the same radius Rₖ are connected to each other in the same direction, so that pairs are created from which a favourable combination is selected, the resulting signal of which best coincides with the main field lift bₒ(t) measured in the magnetic field centre by means of a probe of the magnetic uniform field, for example (Figure 6).

10. Nuclear spin tomograph according to claim 8, characterised in that in order to design the sensor coils (53, 54) for one of the gradients, there are arranged axial-symmetrically on both pole faces (7, 8) in each case a plurality of sensor coils having various radii Rₖ, of which sensor coils in each case those having the same radius Rₖ are connected to each other in opposite directions, so that pairs are created from which a favourable combination is selected, the resulting signal of which best coincides with the gradient field measured in the magnet centre by means of a differential coil, for example (Figure 6).

11. Nuclear spin tomograph according to one of the claims 1 to 10, characterised by a combination of sensor coils for the gradients Gₓ, G_{y} and G_{z} as two flat coils, one of which is respectively arranged on one of the pole faces (7, 8).

12. Nuclear spin tomograph according to claim 11, characterised in that the sensor coils for the gradient Gₓ consist of two coil sections (45, 46), which each form a sector of a circle, the tips of which coil sections act in opposite directions with respect to each other, and in that the sensor coils for the gradient G_{y} likewise consist of two coil sections (47, 48), which each form a sector of a circle, the tips of which coil sections act in opposite directions with respect to each other, and in that the two-coil sections (45, 46) for the gradient Gₓ are rotated by 90° with respect to the coil sections (47, 48) for the gradient G_{y}, and in that these coil sections are surrounded by an annular-disc-shaped sensor coil (49) for the gradient G_{z} (Figure 7).

13. Nuclear spin tomograph according to claim 11, characterised in that each of the flat coils (70, 71) consists of four coil sections (72, 73, 74, 75 and 76, 5 77, 78, 79 respectively) which each form a substantially circular sector of a pole face (7 and 8 respectively), having an aperture angle of 90°, and in each case two (72, 76; 73, 77; 74, 78; 75, 79) of said coil sections are arranged one above the other on the pole faces (7, 8) in the direction of the main field B_{O} and are series-connected in the same direction, and in that these coil sections (72 to 79) are provided with an electronic polarity sign weighting (Figures 8 to 12).

14. Nuclear spin tomograph according to claim 13, characterised in that the two coil sections (72, 76; 73, 77; 74, 78; 75, 79) which are series-connected in the same direction in each case deliver associated output signals (102) by way of a low-pass filter (81 to 88) and an individual pre-amplifier (91 to 98), which output signals for the measured values (Mₓ, M_{y}, M_{z} and M_{bo}) are connected to an operational amplifier (104 to 107) in such a way that the output signal for the coil sections (72, 75, 77, 78 and 73, 74, 76, 79 for Gₓ; 72, 73, 78, 79 and 74, 75, 76, 77 for G_{y}) which are arranged mirror-symmetrically with respect to the gradients Gₓ and G_{y} are weighted with a different polarity sign, and for the gradient G_{z} all coil sections (72 to 79), in each case of one of the two flat coils (70, 71), are weighted with the same polarity sign (Figures 9 to 13).

15. Nuclear spin tomograph according to claim 13, characterised in that an electronic weighting of the coil sections (72 to 75) of the one pole face (7) with a polarity sign which is opposite to that of the coil sections (76 to 79) of the other pole face (8) is provided for the control of the dynamic main field lift bₒ(t) (Figures 12 and 13).

## Revendications

1. Tomographe en spins nucléaires destiné à l'examen d'un corps humain, dont l'axe du corps s'étend en direction de l'axe x d'un système de coordonnées rectangulaires et dont la zone du corps à examiner est située entre les faces polaires planes - pourvues chacune d'au moins une bobine à gradients - d'un aimant à champ principal, dont le champ magnétique principal B_{O} s'étend en direction de l'axe z, caractérisé en ce que les bobines à gradients (11, 12) sont montées en série en sens inverse et branchées sur une source de courant (40) commandée en tension, dont la tension d'entrée est prédéfinie par un régulateur (30) avec un addeur (38) en aval et dont le courant à gradients I_{G} est prévu comme étant une grandeur réglante pour la régulation du flux magnétique Φ des bobines à gradients (11, 12) en fonction de réactions sur le flux magnétique Φ, qui sont créées par des courants de Foucault et des effets de saturation dans le materiau ferromagnétique à proximité des faces polaires (7, 8), et en ce que, pour la saisie du flux magnétique Φ prévue en tant que grandeur de commande, les bobines à gradients (11,12) sont pourvues chacune d'une bobine captrice (13, 14) dont la tension à vide U_{L} est prévue en tant que signal d'entrée pour un passe-bas (36), qui, au-dessus d'une fréquence limite inférieure fᵤ a l'effet d'un intégrateur et dont le signal de sortie au-dessus de la fréquence limite fᵤ est prévu comme étant une valeur de mesure M₁ proportionnelle au flux magnétique Φ pour le régulateur (30). (Figures 2 et 3).

2. Tomographe en spins nucléaires selon la revendication 1, caractérisé en ce que un circuit de réglage commun est associé à chaque fois aux bobines à gradients (11, 12), pour le gradient Gₓ et le gradient G_{y}. (Figure 2).

3. Tomographe en spins nucléaires selon la revendication 1, caractérisé en ce que la grandeur de référence S pour le réglage est attribuée au circuit de réglage par le biais d'un passe-haut (34) complémentaire au passe-bas (36) et en ce que la déviation de réglage est attribuée comme tension de commande par le biais du régulateur (30) à la source de courant (40). (Figure 2).

4. Tomographe en spins nucléaires selon la revendication 1, caractérisé en ce que la grandeur de référence S pour le réglage est attribuée directement à une deuxième entrée de l'addeur (38). (Figure 2).

5. Tomographe en spins nucléaires selon la revendication 1, caractérisé par une régulation supplémentaire de l'amplitude dynamique du champ principal bₒ(t) par les bobines à gradients.

6. Tomographe en spins nucléaires selon la revendication 5, caractérisé en ce que aux deux bobines à gradients (11, 12), pour le gradient G_{z,} est associé à chaque fois un circuit de réglage séparé (Figure 4).

7. Tomographe en spins nucléaires selon la revendication 6, caractérisé en ce que les bobines à gradients (11, 12) sont branchées sur une source de courant (40) commune commandée en tension et en ce que aux bobines captrices (13, 14) est associé à chaque fois un passe-bas (36, 37) dont les signaux de sortie sont attribués à un addeur (39) et à un soustracteur (33), et en ce que le signal de sortie du soustracteur (33) est attribué en tant que signal de mesure M₄ au régulateur (30) et le signal de sortie de l'addeur (39) est attribué en tant que signal de mesure M₅ par le biais d'un régulateur supplémentaire (31) à une source de courant (41) supplémentaire commandée en tension pour une des bobines à gradients (11) en tant que signal d'entrée. (Figure 5).

8. Tomographe en spins nucléaires selon la revendication 6, caractérisé en ce que les deux bobines à gradients (51, 52) sont traversées, pour un des gradients (gradient G_{z} de la figure 6), par des courants à gradients en sens inverse (I₅₁, I₅₂) et qu'elles sont branchées chacune sur une source de courant (60, 61) commandée en tension, dont la tension d'entrée est prédéfinie par un soustracteur (66) ou un addeur (67) respectivement, et en ce que pour le réglage du gradient à ces bobines à gradients (51, 52) est associé à chaque fois une bobine captrice (53, 54) supplémentaire, qui sont montées en série en sens inverse et branchées sur un passe-bas (58), qui, au-dessus d'une fréquence limite inférieure (fᵤ), a l'effet d'un intégrateur et dont le signal de mesure (M₆) intervient en tant que valeur réelle pour un régulateur (30) du circuit de réglage dans le même sens sur les courants à gradients (I₅₁, I₅₂) du gradient G_{z}, et en ce que pour le réglage de l'amplitude dynamique du champ principal bₒ (t) est associée à chaque fois une bobine captrice (55, 56) supplémentaire aux bobines à gradients (51, 52) qui sont montées en série dans le même sens et branchées sur un passe-bas (59), qui, au-dessus d'une fréquence limite inférieure (fᵤ), a l'effet d'un intégrateur et dont le signal de mesure (M₇) proportionnel à l'amplitude dynamique du champ principal bₒ (t) est prévu en tant que valeur réelle pour un régulateur (31) et agit avec un signe de polarité différent sur les deux courants à gradients (I₅₁, I₅₂). (Figure 6).

9. Tomographe en spins nucléaires selon la revendication 8, caractérisé en ce que sont prévues, pour la conception des bobines captrices (55, 56) pour l'amplitude dynamique du champ principal bₒ(t), sur les deux faces polaires (7, 8), à chaque fois plusieurs bobines captrices à rayons Rₖ différents à disposition axisymétrique, dont à chaque fois celles à rayon Rₖ identiques sont liées entre elles dans le même sens de manière à former des paires parmi lesquelles une combinaison favorable est sélectionnée dont le signal résultant correspond le mieux à l'amplitude du champ principal bₒ (t) mesurée au centre du champ magnétique à l'aide par exemple d'une sonde du champ magnétique homogène. (Figure 6).

10. Tomographe en spins nucléaires selon la revendication 8, caractérisé en ce que sont disposées, pour la conception des bobines captrices (53, 54) pour un des gradients sur les deux faces polaires (7, 8), à chaque fois plusieurs bobines captrices à rayons Rₖ différents à disposition axisymétrique, dont celles à chaque fois à rayon Rₖ identiques sont liées entre elles en sens inverse de manière à former des paires parmi lesquelles une combinaison favorable est sélectionnée dont le signal résultant correspond le mieux au champ à gradients mesuré au centre du champ magnétique à l'aide par exemple d'une bobine différentielle. (Figure 6).

11. Tomographe en spins nucléaires selon l'une quelconque des revendications 1 à 10, caractérisé par une combinaison des bobines captrices pour les gradients Gₓ, G_{y} et G_{z} en tant que deux bobines plates, dont chaque fois une est disposée sur une des faces polaires (7, 8).

12. Tomographe en spins nucléaires selon la revendication 11, caractérisé en ce que les bobines captrices pour le gradient Gₓ sont composées de deux bobines partielles (45, 46) qui forment chacune un secteur d'aire de cercle, dont les pointes sont dirigées l'une vers l'autre et en ce que les bobines captrices pour le gradient G_{y} sont également composées de deux bobines partielles (47, 48) qui forment chacune un secteur d'aire de cercle, dont les pointes sont dirigées l'une vers l'autre et en ce que les deux bobines partielles (45,46) pour le gradient Gₓ sont décalées de 90° par rapport aux bobines partielles (47, 48) pour le gradient G_{y} et en ce que ces bobines partielles sont entourées d'une bobine captrice (49) sous forme d'un disque annulaire pour le gradient G_{z}. (Figure 7).

13. Tomographe en spins nucléaires selon la revendication 11, caractérisé en ce que chacune des bobines plates (70, 71) est composée de quatre bobines partielles (72, 73, 74, 75 resp. 76, 77, 78, 79) qui forment chaque fois approximativement un secteur d'aire de cercle d'une face polaire (7 resp. 8) avec un angle d'ouverture de 90° et dont chaque fois deux (72, 76; 73, 77; 74, 78; 75, 79) sont disposées dans le sens du champ principal Bₒ sur les faces polaires (7, 8) l'une au-dessus de l'autre et montées en série dans le même sens, et en ce que ces bobines partielles (72 à 79) sont pourvues d'une pondération électronique de signes de polarité. (Figures 8 à 12).

14. Tomographe en spins nucléaires selon la revendication 13, caractérisé en ce que les deux bobines partielles montées en série dans le même sens (72, 76; 73, 77; 74, 78; 75, 79) fournissent chacune, par le biais d'un passe-bas (81 à 88) et d'un préamplificateur individuel (91 à 98), des signaux de sortie (102) s'y afférant, qui, pour les valeurs de mesure (Mₓ, M_{y}, M_{z}, et M_{bo}), sont branchés sur un amplificateur d'opération (104 à 107) de telle manière que le signal de sortie pour les bobines partielles disposées de manière symétrique par rapport aux gradients Gₓ et G_{y} (72, 75, 77, 78 et 73, 74, 76, 79 pour Gₓ; 72, 73, 78, 79 et 74, 75, 76,77 pour G_{y}), est pondéré de signes différents, et que pour le gradient G_{z} à chaque fois toutes les bobines partielles (72 à 79) d'une des deux bobines plates (70, 71) sont pondérées du même signe. (Figures 9 à 13).

15. Tomographe en spins nucléaires selon la revendication 13, caractérisé en ce qu'est prévu, pour le réglage de l'amplitude dynamique du champ principal bₒ (t), une pondération électronique des bobines partielles (72 à 75) d'une des faces polaires (7) avec un signe opposé par rapport aux bobines partielles (76 à 79) de l'autre face polaire (8). (Figures 12 et 13).
